# DEMANDE DE BREVET EUROPEEN

(11) **EP 3 232 471 A1**
(43) Date de publication de la demande: **18.10.2017**
(21) Numéro de dépôt: 17290043.3
(22) Date de dépôt: 23.03.2017
(51) Int. Cl.: H01L 25/065, H01L 23/13, H01L 23/498

(54) **SYSTÈME ÉLECTRONIQUE POURVU D'UNE PLURALITÉ DE FONCTIONS ÉLECTRONIQUES INTERCONNECTÉES**

(30) Priorité: 12.04.2016 FR 1600616
(71) Demandeur: MBDA France, 92350 Le Plessis-Robinson (FR)
(72) Inventeur: Dupre, René, 92350 Le Plessis Robinson (FR)
(74) Mandataire: Hauer, Bernard

(57) **Abrégé**

Le système électronique (1) comporte un anneau de connexion (2) comprenant une pluralité de couches superposées, alternativement conductrices et isolantes, les couches conductrices (C) superposées étant liées entre elles par des liaisons électriques (5) en formant un réseau d'interconnexion, ledit anneau de connexion (2) comprenant une cavité interne (3), le système électronique (1) comportant également une pluralité de fonctions électroniques (4A, 4B) agencées à l'intérieur de la cavité interne (3) dudit anneau de connexion (2) sur une pluralité de niveaux (N1, N2), avec au moins une fonction électronique (4A, 4B) par niveau (N1, N2), chacune desdites fonctions électroniques (4A, 4B) étant liée à l'anneau de connexion (2) au niveau de la face interne (2A) de ce dernier.

## Description

La présente invention concerne un système électronique pourvu d'une pluralité de fonctions électroniques interconnectées.

Dans le cadre de la présente invention, on entend par fonctions électroniques, tout élément (ou fonction) réalisé de façon électronique et se présentant sous la forme de composants unitaires (composants en boîtier individuel ou en silicium (puce ou circuit intégré, nu)) et/ou de sous-fonctions électroniques utilisant elles-mêmes des composants électroniques unitaires.

Actuellement, les besoins d'intégration des fonctions électroniques requièrent de trouver des solutions techniques pour concentrer un maximum de composants électroniques dans un volume de plus en plus restreint.

Les solutions proposées pour ce faire doivent ne pas être limitatives, c'est-à-dire qu'elles doivent pouvoir répondre à l'intégration, aussi bien de composants individuels que de fonctions électroniques constituées par plusieurs composants.

Dans la plupart des cas, il est prévu une réponse ponctuelle à ce besoin. En effet, les fabricants de composants électroniques proposent des solutions de composants déjà empilés et mis dans un boîtier standard du commerce ou des composants mis dans des boîtiers empilables. Dans ces deux exemples, le fabricant de composants ne peut fournir sa solution de gain de place que pour sa propre famille de composants (des mémoires par exemple), mais il n'offre pas la possibilité d'empiler des composants qu'il a fabriqués en association avec des composants d'un autre fabricant.

Par ailleurs, des solutions d'empilement de fonctions, plus complexes, ne sont pas proposées de façon standard. Il faut passer par des solutions de mise en boîtier « propriétaire ».

Le concept des solutions « propriétaire » usuelles est basé, généralement, sur la réalisation d'un grand composant apte à être reporté par un utilisateur sur une carte support.

La présente invention a pour objet de remédier à ces inconvénients, en proposant un système électronique permettant notamment de concentrer un maximum de fonctions électroniques interconnectées dans un volume restreint.

Selon l'invention, ledit système électronique comporte :
- un anneau de connexion comprenant une pluralité de couches superposées, alternativement conductrices et isolantes, les couches conductrices superposées étant liées entre elles par des liaisons électriques en formant un réseau d'interconnexion, ledit anneau de connexion comprenant une cavité interne ; et
- une pluralité de fonctions électroniques agencées à l'intérieur de la cavité interne dudit anneau de connexion sur une pluralité de niveaux, avec au moins une fonction électronique par niveau, chacune desdites fonctions électroniques étant liée à l'anneau de connexion au niveau de la face interne de ce dernier.

L'anneau de connexion constitue ainsi un système d'interconnexions en trois dimensions utilisables pour réaliser des connexions électriques entre différents niveaux de fonctions électroniques empilées.

Grâce à l'architecture particulière proposée, comprenant cet anneau de connexion et les fonctions électroniques agencées comme précité, on est en mesure de concentrer un maximum de fonctions électroniques interconnectées dans un volume restreint.

Cette architecture est différente de la solution usuelle précitée, car elle repose sur le concept qui consiste à reporter non pas un grand composant, mais de mettre en place un réseau d'interconnexions en trois dimensions. Les connexions électriques entre les niveaux sont organisées en anneau autour des différentes fonctions à relier entre elles.

Avantageusement, l'anneau de connexion présente notamment l'une des formes suivantes :
- une forme cylindrique ;
- une forme parallélépipédique.

En outre, de façon avantageuse, dans l'anneau de connexion, les liaisons électriques entre deux niveaux successifs, sont réalisées via des trous électriquement conducteurs, de préférence métallisés.

Par ailleurs, avantageusement, les fonctions électroniques sont liées à l'anneau de connexion via des connexions électriques qui sont raccordées, d'une part, à des entrées/sorties des fonctions électroniques, et d'autre part, à des plages métallisées situées à l'intérieur de l'anneau de connexion. De préférence, une connexion électrique comprend au moins l'un des éléments suivants :
- un fils métallique ;
- un circuit imprimé flexible.

En outre, avantageusement, le système électronique comporte :
- des connexions surfaciques au moins sur une partie inférieure de l'anneau de connexion ; et/ou
- au moins une entretoise entre deux niveaux de fonctions électroniques, directement successifs. De préférence, l'entretoise comporte au moins un circuit d'interconnexion.

Par ailleurs, de façon avantageuse, les fonctions électroniques agencées sur ladite pluralité de niveaux forment un empilement vertical, et le système électronique comporte au moins un drain thermique agencé sur une face verticalement extrême de l'empilement vertical de fonctions électroniques. De préférence, le système électronique comporte également un joint thermique associé au drain thermique.

En outre, avantageusement, le système électronique comporte deux drains thermiques agencés, respectivement, sur les deux faces verticalement extrêmes de l'empilement vertical de fonctions électroniques.

Par ailleurs, avantageusement, le système électronique comporte au moins un enrobage de résine agencé dans au moins une partie de la cavité interne de l'anneau de connexion.

La présente invention concerne également un procédé d'assemblage d'un système électronique tel que décrit ci-dessus.

Selon l'invention, ledit procédé d'assemblage comporte au moins les étapes suivantes :
- mise en place de connexions de sorties sur un anneau de connexion, l'anneau de connexion comprenant une pluralité de couches superposées, alternativement conductrices et isolantes, les couches conductrices superposées étant liées entre elles par des liaisons électriques en formant un réseau d'interconnexion, ledit anneau de connexion comprenant une cavité interne ;
- agencement de l'anneau de connexion sur un substrat de base ;
- mises en place successives de différents niveaux de fonctions électroniques, à l'intérieur de la cavité interne de l'anneau de connexion, en commençant par la partie inférieure de ce dernier, avec un raccordement, niveau par niveau, d'entrées/sorties avec l'anneau de connexion.

Par ailleurs, dans un mode de réalisation particulier, le procédé d'assemblage comporte, de plus :
- une étape ultérieure de remplissage par une résine d'enrobage d'au moins une partie vide de la cavité interne de l'anneau de connexion ; et/ou
- au moins une étape de mise en place d'au moins une entretoise, entre deux niveaux de fonctions électroniques, cette étape étant mise en oeuvre entre les deux mises en place successives desdits deux niveaux de fonctions électroniques.

En outre, avantageusement, le procédé d'assemblage comporte, de plus, au moins une étape de mise en place d'un drain thermique, cette étape étant mise en oeuvre :
- avant les mises en place successives des différents niveaux de fonctions électroniques, pour un drain thermique dit inférieur ;
- après les mises en place successives des différents niveaux de fonctions électroniques, pour un drain thermique dit supérieur.

Les figures annexées feront bien comprendre comment l'invention peut être réalisée. Sur ces figures, des références identiques désignent des éléments semblables. Plus particulièrement :
- la figure 1 est une vue schématique d'un mode de réalisation particulier d'un système électronique à deux niveaux de fonctions ou d'interconnexions ;
- la figure 2 est une vue schématique d'un anneau de connexion ;
- la figure 3 est une vue schématique d'un anneau de connexion après report sur un substrat d'utilisation ;
- la figure 4 une vue schématique d'un système électronique à deux niveaux d'interconnexions avec une entretoise dite neutre ;
- la figure 5 une vue schématique d'un système électronique à deux niveaux d'interconnexions, le niveau inférieur étant à billes ;
- la figure 6 une vue schématique d'un système électronique à quatre niveaux d'interconnexions avec une entretoise, le niveau inférieur étant à billes ;
- les figures 7 et 8 sont des vues schématiques d'un système électronique pourvu de deux niveaux de fonctions (ou d'interconnexions), respectivement avec un seul drain thermique positionné en partie inférieure, et avec deux drains thermiques positionnés respectivement en partie inférieure et en partie supérieure ; et
- les figures 9A à 9G illustrent différentes étapes successives d'un procédé d'assemblage d'un système électronique conforme à un mode de réalisation préféré de l'invention, pourvu de drains thermiques.

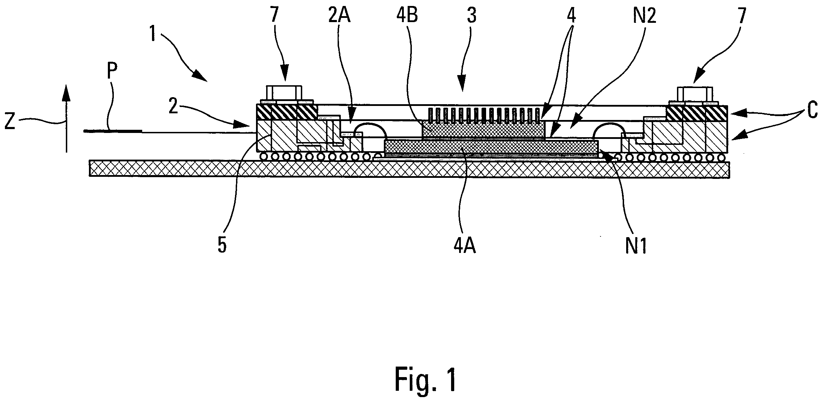

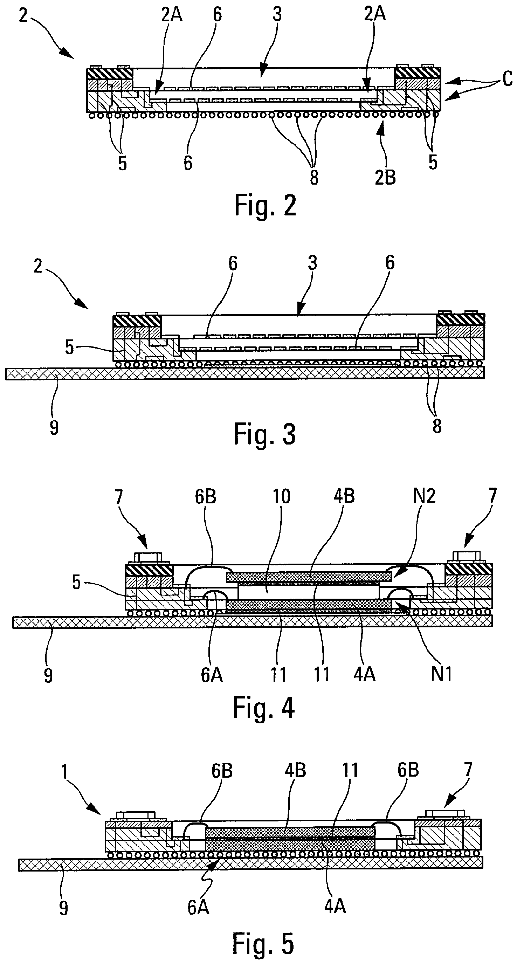

Le système électronique 1 permettant d'illustrer l'invention et représenté schématiquement sur la figure 1, comporte :
- un anneau de connexion 2 tel que représenté sur la figure 2. Cet anneau de connexion 2 comprend une pluralité de couches conductrices superposées, et séparées entre elles par des couches isolantes. Les couches conductrices C superposées sont liées, entre elles, par des liaisons électriques précisées ci-dessous de manière à former un réseau d'interconnexions. L'anneau de connexion 2 comprend une cavité interne 3 ; et
- une pluralité de fonctions électroniques 4 agencées à l'intérieur de la cavité interne 3 de l'anneau de connexion 2 sur une pluralité de niveaux superposés N1, N2,... avec au moins une fonction électronique par niveau, à savoir la fonction 4A sur le niveau N1 et la fonction 4B sur le niveau N2 dans l'exemple de la figure 1.

Chacune desdites fonctions électroniques 4 est liée à l'anneau de connexion 2 au niveau de la face annulairement interne 2A de ce dernier.

L'anneau de connexion 2 comprend ainsi un empilement de couches isolantes et conductrices formant un système (ou réseau) d'interconnexions électriques en trois dimensions, qui est utilisable pour réaliser des connexions électriques entre différents niveaux N1, N2,... de fonctions électroniques 4 empilées.

L'empilement des couches dans l'anneau de connexion 2 et l'empilement des niveaux N1, N2 de fonctions, par exemple jusqu'à quinze niveaux, sont réalisés selon une direction Z dite verticale, qui est orthogonale à un plan P dit horizontal, dans lequel ou parallèlement auquel sont positionnés les empilements.

Grâce à cette architecture particulière comprenant l'anneau de connexion 2 et les fonctions 4 agencées comme précité, le système électronique 1 est en mesure de concentrer un maximum de fonctions électroniques 4 interconnectées dans un volume restreint.

L'anneau de connexion 2 peut, notamment, être de forme cylindrique, de forme parallélépipédique ou de toute autre forme de courbe fermée, adaptée à l'application envisagée. L'anneau de connexion 2 est donc évidé en son milieu de manière à créer l'espace interne 3 cylindrique, destiné à recevoir les fonctions électroniques élémentaires qui doivent être interconnectées entre elles.

L'architecture du système électronique 1 comprend ainsi un réseau d'interconnexions en trois dimensions, dans lequel les connexions électriques entre les niveaux sont organisées en anneau autour des différentes fonctions à relier entre elles.

Dans l'anneau de connexion 2, les liaisons électriques 5 entre deux niveaux successifs, représentées notamment sur les figures 1 et 2, sont réalisées via des trous électriquement conducteurs, de préférence métallisés. Par conséquent, les interconnexions entre les différents niveaux de l'anneau de connexion 2 (liaisons électriques internes) se font dans le plan vertical Z (à l'intérieur de murs latéraux de l'anneau de connexion 2) par l'intermédiaire de trous métallisés. Ces métallisations peuvent être de différentes natures (cuivre, argent, palladium, or, carbone,...).

Par ailleurs, les fonctions électroniques 4 sont liées à l'anneau de connexion 2 via des liaisons électriques 6 (représentées notamment sur les figures 2 et 3) qui sont raccordées, d'une part, à des entrées/sorties des fonctions électroniques 4, et d'autre part, à des plages métallisées situées à l'intérieur de la cavité interne 3 de l'anneau de connexion 2 et disposées suivant les besoins.

Le raccordement des fonctions électroniques 4 est donc réalisé sur la face interne 2A de l'anneau de connexion 2, par l'intermédiaire des liaisons électriques 6 qui peuvent se présenter sous forme de connexions électriques telles que des fils métalliques de différentes natures, des circuits imprimés flexibles ou toutes autres formes susceptibles d'assurer une connexion électrique entre la fonction 4 considérée et l'anneau de connexion 2.

Les liaisons électriques, internes au système électronique 1, sont ainsi réalisées dans un plan parallèle au plan P par des liaisons conductrices (liaisons 6) de type métallique, et entre plans, par des trous conducteurs (liaisons 5), tels que des trous métallisés assurant dans la direction verticale Z les connexions entre les niveaux.

Si nécessaire, l'anneau de connexion 2 peut également recevoir des composants électroniques 7 de type passif (résistances, condensateurs, selfs), comme représenté notamment sur les figures 1 et 4 à 8. Ces composants passifs 7 peuvent être des composants de découplage (condensateur) ou d'adaptation (résistances : « pullup », « pulldown », adaptation).

Ces composants passifs 7 peuvent être rapportés en surface (comme représenté sur les figures 1 et 4 à 8) ou être intégrés à l'intérieur de l'anneau de connexion 2.

Par ailleurs, des connexions surfaciques 8 sont prévues à la partie inférieure 2B (dans le sens Z), c'est-à-dire à la base, de l'anneau de connexion 2, comme représenté sur la figure 2. Elles sont destinées à réaliser des liaisons électriques entre l'anneau de connexion 2 et un substrat 9 d'utilisation (ou de base), tel qu'une carte, sur lequel est monté le système électrique 1, comme représenté sur la figure 3.

En outre, dans un mode de réalisation particulier, le système électronique 1 comporte au moins une entretoise 10 (ou plaque intercalaire) qui est agencée entre deux niveaux N1 et N2 de fonctions électroniques 4A et 4B, directement successifs, comme illustré sur la figure 4. Les fonctions électroniques 4A et 4B sont fixées par des joints de colle 11. Une telle entretoise 10 a pour objet d'amener la fonctions 4B du niveau N2 à la même hauteur selon la direction Z que la couche conductrice associée à ce niveau de l'anneau de connexion 2, pour pouvoir réaliser les connexions entre l'anneau de connexion 2 et la fonction 4B du niveau N2 considéré dans un plan parallèle au plan P.

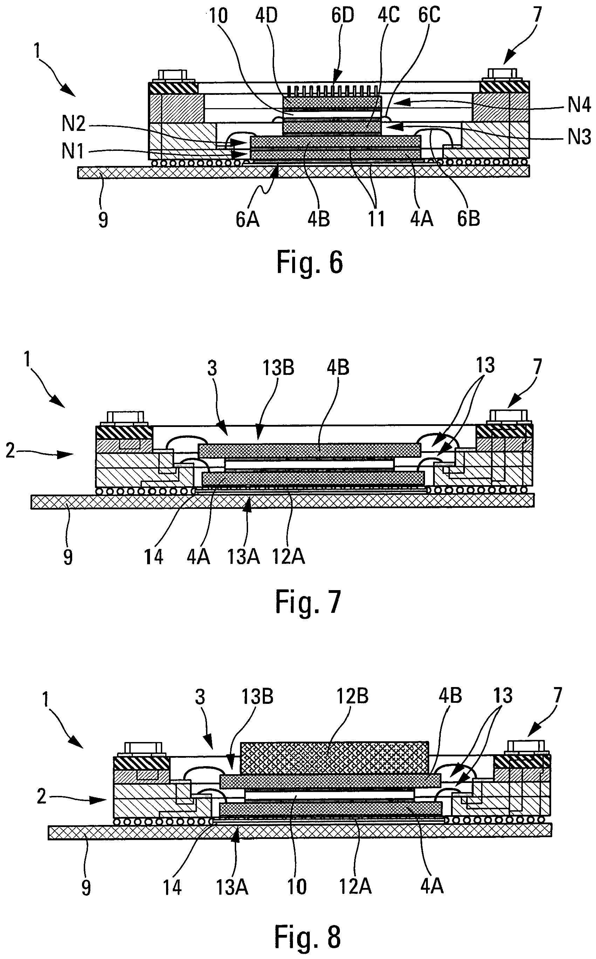

A titre d'illustration, les figures 4 et 6 montrent une entretoise 10 entre deux niveaux, à savoir entre les niveaux N1 et N2 sur la figure 4, et entre des niveaux N3 et N4 (comprenant des fonctions électroniques 4C et 4D) sur la figure 6. Sur la figure 6, on a également représenté les connexions électriques 6A, 6B, 6C et 6D internes.

Dans un mode de réalisation simplifié, cette entretoise 10 est simplement une entretoise mécanique (entretoise neutre), dont l'objet est uniquement de réaliser un ajustement de la position verticale afin de pouvoir permettre la réalisation des connexions de sorties de la fonction électronique.

En revanche, dans un mode de réalisation particulier, l'entretoise 10 peut également comporter un circuit d'interconnexions entre deux niveaux adjacents. Dans ce cas, l'entretoise est dite active.

Par ailleurs, dans un mode de réalisation préféré, le système électronique 1 comporte au moins un drain thermique 12A et 12B qui est agencé sur une face verticalement extrême (selon l'axe Z) de l'empilement vertical 13 de fonctions électroniques 4A et 4B, comme représenté sur les figures 7 et 8.

Ce drain thermique 12A, 12B génère un drainage thermique permettant de ramener sur une surface la chaleur émise par les fonctions électroniques 4A, 4B intégrées au milieu de l'anneau de connexion 2 (dans la cavité interne 3).

De préférence, on agence les fonctions électroniques qui chauffent le plus à proximité de ce drain thermique 12A, 12B.

L'ajout de cette fonction de drainage thermique permet également d'utiliser n'importe quel type d'entretoise, active ou neutre.

De préférence, le système électronique 1 comporte également un joint thermique 14 associé au drain thermique 12A , comme représenté sur les figures 7 et 8.

Les figures 7 et 8 illustrent des exemples d'un système électronique 1 nécessitant un drainage thermique. Ce drainage thermique peut être réalisé sur une seule face 13A (figure 7), ou sur les deux faces 13A et 13B verticalement extrêmes de l'empilement vertical 13 de fonctions électroniques 4A et 4B.

Par ailleurs, le système électronique 1 peut comporter au moins un enrobage de résine (non représenté) qui est introduit dans la partie vide de la cavité interne 3 de l'anneau de connexion 2. Cet enrobage permet, notamment, de rendre le système électronique 1 plus robuste.

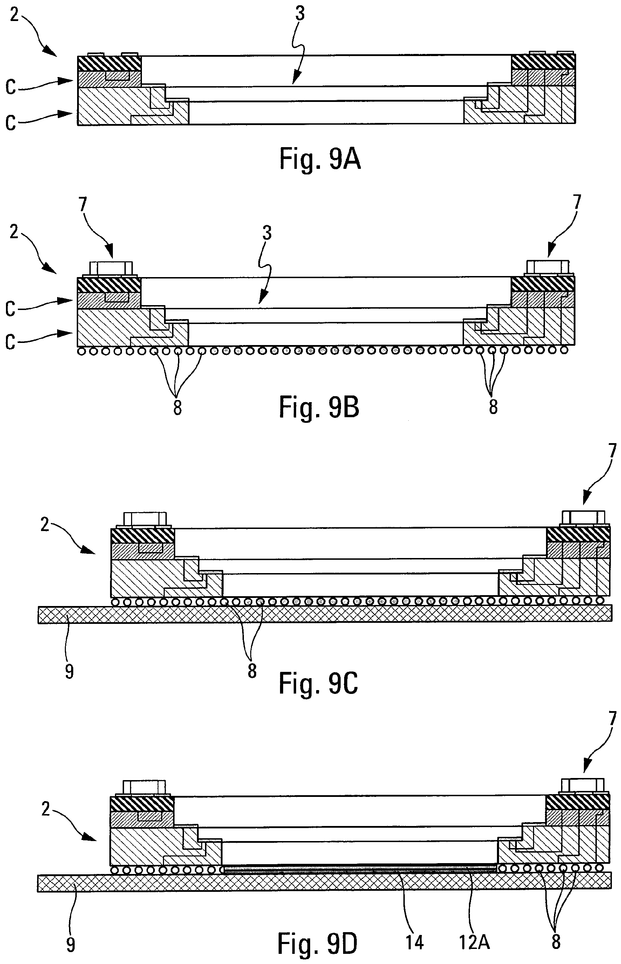

Le système électronique 1, tel que décrit ci-dessus, peut être assemblé par l'intermédiaire d'un procédé d'assemblage précisé ci-après en référence aux figures 9A à 9G.

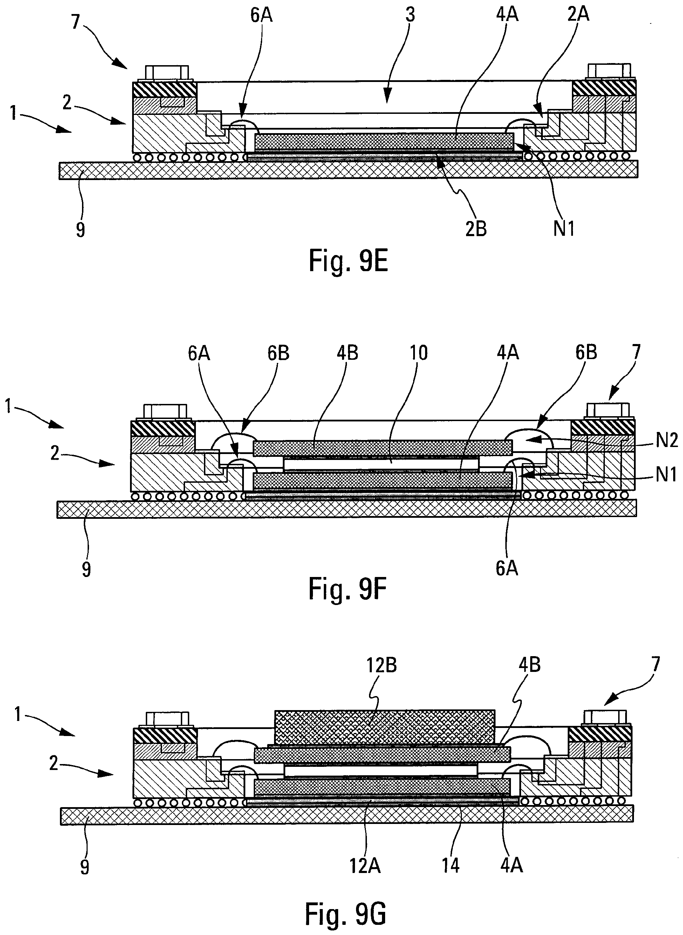

Ce procédé d'assemblage comporte au moins les étapes suivantes :
- une étape de mise en place sur l'anneau de connexion 2, tel que celui représenté sur la figure 9A, de composants passifs 7 et d'entrées/sorties 8 de l'anneau de connexion 2, comme montré sur la figure 9B. L'anneau de connexion 2 comprend, comme indiqué ci-dessus, une pluralité de couches superposées, alternativement conductrices et isolantes. Les couches conductrices C superposées sont liées entre elles par des liaisons électriques en formant un réseau d'interconnexions. L'anneau de connexion 2 comprend également une cavité interne 3 ;
- une étape d'agencement de l'anneau de connexion 2 sur un substrat 9 de base, comme représenté sur la figure 9C ;
- une étape de mise en place d'un drain thermique 13A dit inférieur, via un joint thermique 14, sur le substrat 9 de base, comme représenté sur la figure 9D ;
- des étapes successives de mises en place des différents niveaux N1, N2 de fonctions électroniques, à l'intérieur de la cavité interne 3 de l'anneau de connexion 2. Pour ce faire, on commence par la partie inférieure 2B de l'anneau de connexion 2, comme représenté pour la fonction électronique 4A du premier niveau N1 sur la figure 9E, et on réalise un raccordement, niveau par niveau, des entrées/sorties des fonctions électroniques avec l'anneau de connexion 2 ;
- au moins une étape de mise en place d'au moins une entretoise 10, entre deux niveaux N1 et N2 successifs de fonctions électroniques 4A et 4B. Une telle étape est mise en oeuvre entre les deux mises en place successives desdits deux niveaux N1 et N2 considérés. Elle est suivie par une étape de mise en place de la fonction électronique 4B au second niveau N2 comme représenté sur la figure 9F ; et
- une étape de mise en place d'un drain thermique 12B dit supérieur, via un joint d'assemblage (colle), comme représenté sur la figure 9G.

Par ailleurs, dans un mode de réalisation particulier, le procédé d'assemblage peut comporter, de plus, une étape de remplissage par une résine d'enrobage (non représentée) d'au moins une partie vide de la cavité interne 3 de l'anneau de connexion 2.

Le système 1, tel que décrit ci-dessus, présente ainsi notamment les avantages suivants :
- il permet l'utilisation pour les fonctions électroniques de tous les types possibles de composants, encapsulés ou non, et en particulier des composants passifs 7 et/ou des composants actifs 4A à 4D, qui peuvent être fournis par des fabricants différents ;
- il réalise (via l'anneau de connexion 2) l'interconnexion électrique des fonctions électroniques 4A à 4D empilées et positionnées à différents niveaux N1 à N4 ;
- il est utilisable avec les principaux substrats 9 usuels, utilisés dans la fabrication des fonctions électroniques (matériaux organiques ou minéraux) ;
- il présente la capacité, si nécessaire, d'intégrer un ou plusieurs drains thermiques 12A, 12B ;
- il protège les liaisons électriques entre niveaux contre des tentatives de lecture parasite. En effet, ces liaisons ne sont pas accessibles, à la différence de certaines solutions techniques qui laissent apparaître à nu des connexions entre niveaux en périphérie, ce qui constitue une source potentielle d'espionnage de la fonction ainsi constituée ; et
- la cavité centrale 3 de l'anneau de connexion 2 peut être protégée, en étant remplie de résine d'enrobage.

## Revendications

1. Système électronique pourvu d'une pluralité de fonctions électroniques interconnectées,
**caractérisé en ce qu'**il comporte :
- un anneau de connexion (2) comprenant une pluralité de couches superposées, alternativement conductrices et isolantes, les couches conductrices (C) superposées étant liées entre elles par des liaisons électriques (5) en formant un réseau d'interconnexion, ledit anneau de connexion (2) comprenant une cavité interne (3) ; et
- une pluralité de fonctions électroniques (4) agencées à l'intérieur de la cavité interne (3) dudit anneau de connexion (2) sur une pluralité de niveaux (N1, N2, N3, N4), avec au moins une fonction électronique (4) par niveau, chacune desdites fonctions électroniques (4) étant liée à l'anneau de connexion (2) au niveau de la face interne (2A) de ce dernier.

2. Système électronique selon la revendication 1,
**caractérisé en ce que** l'anneau de connexion (2) présente l'une des formes suivantes :
- une forme cylindrique ;
- une forme parallélépipédique.

3. Système électronique selon l'une des revendications 1 et 2, **caractérisé en ce que**, dans l'anneau de connexion (2), les liaisons électriques (5) entre deux niveaux successifs (N1, N2, N3, N4), sont réalisées via des trous électriquement conducteurs.

4. Système électronique selon l'une quelconque des revendications 1 à 3,
**caractérisé en ce que** les fonctions électroniques (4) sont liées à l'anneau de connexion (2) via des connexions électriques (6) qui sont raccordées, d'une part, à des entrées/sorties des fonctions électroniques (4), et d'autre part, à des plages métallisées situées à l'intérieur de l'anneau de connexion (2).

5. Système électronique selon l'une quelconque des revendications précédentes,
**caractérisé en ce qu'**il comporte des connexions surfaciques (8) au moins sur une partie inférieure (2B) de l'anneau de connexion (2).

6. Système électronique selon l'une quelconque des revendications précédentes,
**caractérisé en ce qu'**il comporte au moins une entretoise (10) entre deux niveaux (N1, N2) de fonctions électroniques (4A, 4B), directement successifs.

7. Système électronique selon la revendication 6,
**caractérisé en ce que** l'entretoise (10) comporte au moins un circuit d'interconnexion.

8. Système électronique selon l'une quelconque des revendications précédentes,
**caractérisé en ce que** les fonctions électroniques (4) agencées sur ladite pluralité de niveaux forment un empilement vertical (13), et **en ce que** le système électronique (1) comporte au moins un drain thermique (12A, 12B) agencé sur une face verticalement extrême de l'empilement vertical (13) de fonctions électroniques (4).

9. Système électronique selon la revendication 8,
**caractérisé en ce qu'**il comporte un joint thermique (14) associé au drain thermique (12A).

10. Système électronique selon l'une des revendications 8 et 9,
**caractérisé en ce qu'**il comporte deux drains thermiques (12A, 12B) agencés, respectivement, sur les deux faces verticalement extrêmes (13A, 13B) de l'empilement vertical (13) de fonctions électroniques (4).

11. Système électronique selon l'une quelconque des revendications précédentes,
**caractérisé en ce qu'**il comporte au moins un enrobage de résine agencé dans au moins une partie de la cavité interne (3) de l'anneau de connexion (2).

12. Procédé d'assemblage d'un système électronique selon l'une quelconque des revendications 1 à 11,
**caractérisé en ce qu'**il comporte au moins les étapes suivantes :
- mise en place de connexions de sorties sur un anneau de connexion (2), l'anneau de connexion (2) comprenant une pluralité de couches superposées, alternativement conductrices et isolantes, les couches conductrices (C) superposées étant liées entre elles par des liaisons électriques (5) en formant un réseau d'interconnexion, ledit anneau de connexion (2) comprenant une cavité interne (3) ;
- agencement de l'anneau de connexion (2) sur un substrat (9) de base ;
- mises en place successives de différents niveaux (N1, N2, N3, N4) de fonctions électroniques (4), à l'intérieur de la cavité interne (3) de l'anneau de connexion (2), en commençant par la partie inférieure de ce dernier, avec un raccordement, niveau par niveau, d'entrées/sorties avec l'anneau de connexion (2).

13. Procédé selon la revendication 12,
**caractérisé en ce qu'**il comporte, de plus, une étape ultérieure de remplissage par une résine d'enrobage d'au moins une partie vide de la cavité interne (3) de l'anneau de connexion (2).

14. Procédé selon l'une des revendications 12 et 13,
**caractérisé en ce qu'**il comporte, de plus, au moins une étape de mise en place d'un drain thermique (12A, 12B), cette étape étant mise en oeuvre :
- avant les mises en place successives des différents niveaux (N1, N2) de fonctions électroniques (4), pour un drain thermique (12A) dit inférieur ;
- après les mises en place successives des différents niveaux (N1, N2) de fonctions électroniques (4), pour un drain thermique (12B) dit supérieur.

15. Procédé selon l'une quelconque des revendications 12 à 14,
**caractérisé en ce qu'**il comporte, de plus, au moins une étape de mise en place d'au moins une entretoise (10), entre deux niveaux (N1, N2) de fonctions électroniques (4), cette étape étant mise en oeuvre entre les deux mises en place successives desdits deux niveaux (N1, N2) de fonctions électroniques (4).
